# EUROPEAN PATENT APPLICATION

(11) **EP 4 560 861 A1**
(43) Date of publication of application: **28.05.2025**
(21) Application number: 24315521.5
(22) Date of filing: 15.11.2024
(51) Int. Cl.: H02H 3/087, H02H 9/00, H03K 17/082

(54) **DRIVER APPARATUS AND CORRESPONDING METHOD**

(30) Priority: 27.11.2023 IT 202300025164
(71) Applicant: STMicroelectronics International N.V., 1228 Plan-les-Ouates, Geneva (CH)
(72) Inventor: Castro, Enrico, 95125 CATANIA (IT); Trecarichi, Calogero Andrea, 93012 GELA (CALTANISSETTA) (IT); Castellan, Julia, 13530 TRETS (FR); Bienvenu, Philippe, 83470 SAINT-MAXIMIN LA SAINTE BAUME (FR)
(74) Representative: Buzzi, Notaro & Antonielli d'Oulx S.p.A.

(57) **Abstract**

Embodiments of a driver apparatus (20) for use in automotive power distribution applications featuring different current loads, for instance, comprise a plurality of channels (CH) configured to drive one or more electrical loads and a control module (1008) configured to generate control signals to operate at least one channel in the plurality of channels (CH).

The driver apparatus (20) as disclosed comprises an electronic fuse (200) configured to monitor one or more operating parameter in a respective channel (CH) and to detect anomalous conditions in that channel based on the parameter(s) monitored plus a parallel-mode block (202) configured to define one or more sets of channels including two or more channels configured to drive a same load.

The control module (1008) is configured to receive from the parallel-mode block (202) parallel-mode management control signals and to operate the channels in the set of channels based on parallel-mode management control signals received by the parallel-mode block (202). The electronic fuse (200) is configured to make the channels in the set of channels non-conductive in response to an anomalous condition detected even in just one channel in the set.

## Description

### Technical field

The description relates to electronic circuits.

One or more embodiments can be applied to electronic circuits such as, for instance, High-Side Drivers, HSDs circuits.

### Background

High-side drivers are widely used in automotive applications in order to couple loads to voltage supplies.

Usually, such high-side drivers may integrate a digital or analog control circuit with a vertical power transistor, obtaining VIPower HSDs ("Vertical Intelligent Power High-Side Drivers").

Therefore, such VIPower HSDs are monolithic silicon chips combining both control and protection circuitry with one or more standard Power MOSFETs, having a power-stage current flowing vertically therein.

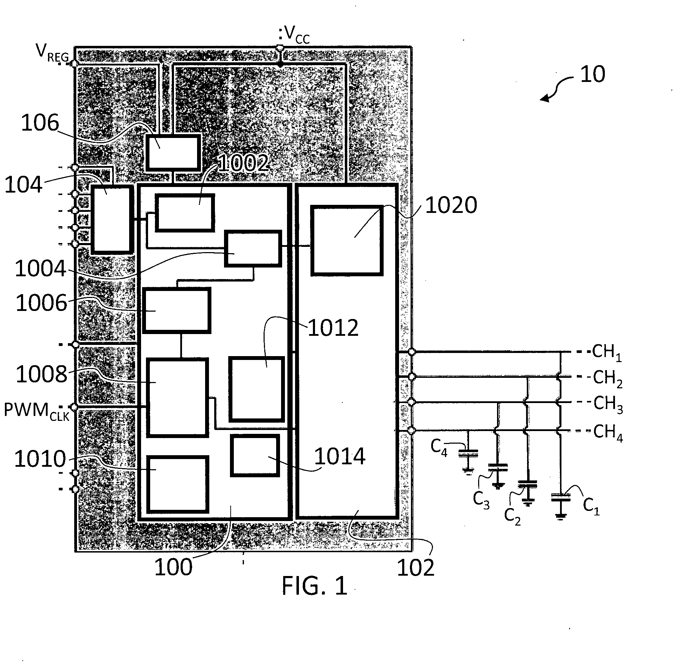

Figure 1 illustrates a block diagram of a high-side driver 10 (for instance, a VIPower HSD) comprising a logic section 100 (supplied by a regulated voltage V_{REG} generated by a voltage regulator 106) and a section containing gate drivers and MOSFETs 102 (supplied with a supply voltage Vcc).

For instance, the logic section 100 may comprise blocks out of a watchdog unit 1002, an ADC ("Analog-to-Digital Converter") 1004, a priority manager 1006, a PWM ("Pulse-Width Modulation") engine 1008, an OTP ("One-Time-Programmable Memory") 1010, a block containing flags 1012, and a reverse battery block 1014.

The watchdog unit 1002 can be configured to receive a serial signal from a SPI ("Serial Peripheral Interface") block 104 and to implement one or more watchdog timers, that is, one or more timers used to detect and recover from malfunctions.

The ADC 1004 can be configured to receive the serial signals from the SPI block 104, to convert internal analog signals, such as internal analog currents proportional to output ones, into digital vectors, and to provide such internal analog currents and such digital vectors to a priority manager block 1006 (for instance, if a plurality of output channels, collectively referred to as CH, is present) or to a PWM engine 1008 (for instance, if a single output channel CH is present).

Depending on the number of the output channels (for instance, if a plurality of output channels, collectively referred to as CH, is present), the priority manager block 1006 or the PWM engine 1008 can be configured to multiplex the received internal analog currents and to store the digital converted data, that is, such received digital vectors, into given registers.

In this way, an external elaboration unit, for instance, a microcontroller or the like, may read data from such given registers.

In fact, the high-side driver 10 may contain:
a single output channel CH comprising a single integrated power MOSFET, or
a plurality of output channels, for instance, up to four output channels CH₁, CH₂, CH₃, and CH₄ (collectively referred to as CH), with respective integrated power MOSFETs, so that different loads may be driven by a same high-side driver 10 (for instance, a single load may be driven by each channel CH, that is, by each of the respective integrated power MOSFETs).

The priority manager 1006 can be configured to receive such analog signals and, if a plurality of channels is to be operated, to manage channel conversion arbitration and synchronization.

If the high-side driver 10 contains a single output channel CH, the priority manager 1006 may be configured to address a same single output channel CH.

Such priority manager 1006 can be further configured to provide priority control signals to the ADC block 1004, such priority control signals containing information on channel conversion arbitration and synchronization.

The PWM engine 1008 can be configured to receive an external PWM clock signal PWM_{CLK} and the digital signals from the SPI block 104, and generate based on of the received signals one or more channel control signals (that is, one or more PWM signals) for operating either a single channel CH or a set of channels in a plurality of channels CH (either a single channel in such plurality of channels, all the channels in such plurality of channels, or a subset comprising any number of channels of such plurality of channels) through respective output terminals.

The channel control signals, that is, the PWM signals generated by the PWM engine 1008, can be used to operate either such single channel CH or such set of channels of the plurality of channels CH, thus, as each of the channels CH may be implemented using a respective power MOSFET, such channel control signals can be used to drive through respective gate terminals a number of power MOSFETs equal to the number of channels in either such single channel CH or such set of channels of the plurality of channels CH.

Therefore, such one or more power MOSFETs comprised within respective one or more channels CH (for instance, in the section containing gate drivers and MOSFETs 102) are configured to have:
their gate terminal coupled with a respective output terminal of the PWM engine 1008,
their drain terminal coupled to the supply voltage Vcc, and
their source terminal coupled to respective capacitors (for instance, C₁, C₂, C₃, and C₄ - collectively referred as C - of Figure 1) and respective loads (to be coupled to respective channels and not shown in Figure 1).

The OTP 1010 and the block containing flags 1012 may contain information used by other blocks in order to perform their functions or, for instance, may contain information for expanded monitoring options or configuration information for implementing, for instance, auto-restart or latch-off functions.

The (optional) reverse battery block 1014 can be configured to perform protection functions, for instance, by providing self-turn-on functions for the one or more power MOSFETs comprised in the one or more channels CH.

For each channel CH, the section containing gate drivers and MOSFETs 102 advantageously contain a current sense block 1020 coupled to the source terminal of a power MOSFET comprised in each channel and configured to sense the value of the current flowing therein and to provide the value of such sensed current as feedback to the ADC 1004.

If a plurality of channels CH is present, the section containing gate drivers and MOSFETs 102 may further contain a current sense block 1020 and a current sense multiplexer, such current sense block 1020 being configured to sense the value of the current flowing within each of the channels in the plurality of channels CH (for instance, by being coupled to the source terminal of a corresponding power MOSFET comprised in a considered channel) and to send each of the values of such sensed currents to respective input terminals of the current sense multiplexer.

Thus, such current sense multiplexer is configured to select the value of a given sensed current out of the plurality of values of the sensed currents received at its input terminals and to provide such selected value of the given sensed current as feedback to the ADC 1004.

Usually, vehicles comprise one or more silicon devices, each of them integrating a plurality of high-side drivers 10 with different current capabilities used to drive loads with different current requirements.

Such a solution for managing loads with different current requirements may lead to large occupied areas as a plurality of high-side drivers 10 is to be integrated within a same silicon device.

Therefore, solutions that facilitate reducing the number of high-side drivers integrated within a single silicon device without reducing robustness and compatibility with loads having different current requirements would be beneficial in order to reduce the occupied areas and the amount of circuitry used, still providing compatibility with different types of loads.

### Object and summary

An object of one or more embodiments is to contribute in providing such a solution.

According to one or more embodiments, that object is achieved via a circuit (a driver apparatus, for instance, a high-side driver, HSD circuit, for instance) having the features set forth in the claims that follow.

One or more embodiments concern a related method of operation.

The claims are an integral part of the technical teaching provided in respect of the embodiments.

Solutions as described herein include a driver apparatus, for instance, a high-side driver apparatus, comprising:
a plurality of channels configured to drive one or more loads, and
a control module configured to generate one or more channel control signals to operate one or more of such channels.

Solutions as described herein may further comprise:
an electronic fuse ("E-Fuse") configured to monitor one or more parameters in a respective channel in the plurality of channels and to use such one or more monitored parameters to detect anomalous conditions on the respective channel, and
a parallel-mode block configured to define one or more sets of channels (wherein each set of channels comprises at least two channels), the channels in a same set of channels being configured to drive a same load.

In addition, the control module of solutions as described herein may be further configured to receive from the parallel-mode block management control signals and to operate the channels in the one or more sets of channels based on the received management control signals.

The electronic fuse of solutions as described herein may be further configured to make the channels in a same set of channels non-conductive in response to an anomalous condition detected in one or more channels in such same set of channels.

In embodiments, a high-side driver apparatus as described herein may comprise an additional module configured to provide compatibility with load comprising one or more capacitive components that are to be pre-charged (that is, candidate for pre-charging).

In embodiments, a high-side driver apparatus as described herein may comprise one or more BISTs circuitry configured to check if functional safety requirements of an analog to digital converter comprised therein and/or of implemented harness protections are met.

In embodiments, a high-side driver apparatus as described herein may comprise an enhanced digital power supply comprising a capacitor configured to be charged in order to supply a dedicated pin in case of falls of a global supply voltage.

Solutions as described herein facilitate reducing the number of high-side drivers integrated within a single silicon device without reducing robustness and compatibility with loads having different current requirements in order to reduce the occupied areas and the amount of circuitry used, still providing compatibility with different types of loads.

### Brief description of the figures

One or more embodiments will now be described, by way of example only, with reference to the annexed figures, wherein:
Figure 1 is a block diagram of a high-side driver;
Figure 2 is a block diagram of a high-side driver according to embodiments of the present description;
Figure 3 is a diagram comprising steps and components involved in the operation of a high-side driver according to embodiments of the present description in presence of capacitive loads;
Figure 4 is a time diagram of the behavior of signals related to a high-side driver when operated according to the diagram of Figure 3 according to embodiments of the present description;
Figure 5 is part of a BIST ("Built in Self-Test") used in high-side drivers according to embodiments of the present description; and
Figure 6 is an enhanced digital power supply used in high-side drivers according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

A possible application context of solutions as described herein may be an automotive context, for instance, solutions as described herein may be used in automotive power distribution applications featuring different current loads.

Power distribution domains comprising high-side drivers requiring a compatibility with loads having different current requirements in order to enhance compatibility with different types of loads are exemplary of possible applications of embodiments.

It is noted that even if the following description is mainly focused on automotive applications, solutions as described herein may be used also in different applications and contexts comprising drivers, such as high-side drivers, for instance, for which compatibility with loads having different current requirements is a desirable feature,

As previously described, solutions as described herein aim at facilitating the reduction of the number of high-side drivers integrated within a single silicon device without reducing robustness and compatibility with loads having different current requirements in order to reduce the occupied areas and the amount of circuitry used, still providing compatibility with different types of loads.

Hence, in response to the current requirement of a given load being higher than the current that can be provided by a single channel (that is, by a single power MOSFET comprised in such single channel), solutions as described herein may be configured to parallelize the channels comprised in a set of channels of the plurality of channels CH in order to drive the given load using more than one channel (that is, using each of the channels comprised in such set of channels) through the actuation of the channels comprised in such set of channels on such same given load.

Otherwise, in response to the current requirement of a given load being lower than or equal to the current that can be provided by a single channel (that is, by a single power MOSFET comprised in such single channel), solutions as described herein may be configured to drive such given load using a single channel through the actuation of such single channel on such given load.

It is noted that, if a plurality of loads having current requirements higher than the current that can be provided by a single channel is present, solutions as described herein may be configured to parallelize channels comprised in more than one set of channels, for instance, in a number of set of channels equal to the number of loads in such plurality of loads, wherein each of the channels comprised in a same set of channels is configured to drive a same load in such plurality of loads.

Therefore, each of the channels comprised in a same set of channels is actuated on a same respective load in such plurality of loads, while channels comprised in different set of channels are actuated on different respective load in such plurality of loads.

It is noted that the number of channels driving a same given load and comprised in a same set of channels may depend on the current requirement of such given load. For instance, based on the current requirement of a load, either a single channel, a subset of the plurality of channels CH, or all the channels in the plurality of channels CH, may be used to drive such load.

For instance, parallelized channels, that is, the channels comprised in a same set of channels of the plurality of channels CH and actuated on a same load, may comprise respective power MOSFETs with a same or a different current capability, thus, the number of channels driving a same given load and comprised in a same set of channels may also depend on the current capabilities of the respective power MOSFETs comprised therein:
Therefore, to select a different current capability of the high-side driver 20 in order to drive a load with a current requirement higher than the current that can be provided by a single channel, a higher number of channels (that is, more than one single channel) is to be used to drive such load, such channels being comprised in a same set of channels and being selected considering both the current requirement of such load and the current capabilities of the respective power MOSFETs comprised therein.

It is noted that the higher the number of channels selected to drive a single load, the higher may be the current requirement of such single load, that is, the current required for driving such single load.

As already described, it is noted that such parallelization may be disabled if the current capability requested from a give load can be provided by a single channel.

In addition, it is noted that such parallelization may be selectively enabled for a subset of channels of the plurality of channels CH, thus, such subset of channels may be operated in a parallelized mode (that is, channels comprised in such subset of channels may be configured to drive a same load).

In such a case, channels not comprised in such subset of channels may be operated in a standard mode, that is, in order to individually drive a respective load (that is, each of such channels not comprised in such subset of channels may be used to drive a respective load).

It is further noted that such parallelization may be selectively enabled for a plurality of sets of channels wherein each of such sets of channels comprise channels that may be configured to drive a same load while channels comprised in different sets of channels may be configured to drive different loads, for instance, a first set may comprise a pair of channels configured to drive a same first load and a second set may comprise three channels configured to drive a same second load.

In certain applications, using a plurality of channels to drive a single load may result in failures such as thermal shutdown, EMI ("ElectroMagnetic Interference" - for instance, sustaining residual demagnetization energy using an unbalanced equivalent power MOSFET), switching loss, and hazard that can destroy one or more of the channels.

For instance, if the balance of the currents flowing within parallelized channels (that is, channels comprised in a same set of channels and actuated on a same coupled load) relies on:
an external synchronization of channel control signals (therefore, protection mechanisms are not synchronized for channels driving a same coupled load), and
the balancing of external tracks/circuit traces coupling a high-side driver to such coupled load.

In case of a thermal event on at least one of the parallelized channels (so that no current flows therein), the currents flowing within the others of the parallelized channels increase in order to provide to the coupled load the amount of current required to drive such coupled load, resulting in an overstressing of such others of the parallelized channels and leading to a possible destruction of one or more of them.

Therefore, solutions able to manage parallelized channels, that is, channels comprised in a same set of channels and actuated on a same load, synchronously may advantageously reduce the probability of having failures as that previously described, for instance, by favoring the balance of the currents flowing within such parallelized channels.

Hence, in solutions as described herein, the activation of the channels may be managed internally and the channels internal protections and diagnosis may be performed on the parallelized channels as a group (even if such internal protections and diagnosis may be individually active for each of the parallelized channels) and not on each of such parallelized channels individually.

Harness protections may be kept apart using the average of the currents flowing within the parallelized channels as tripping current.

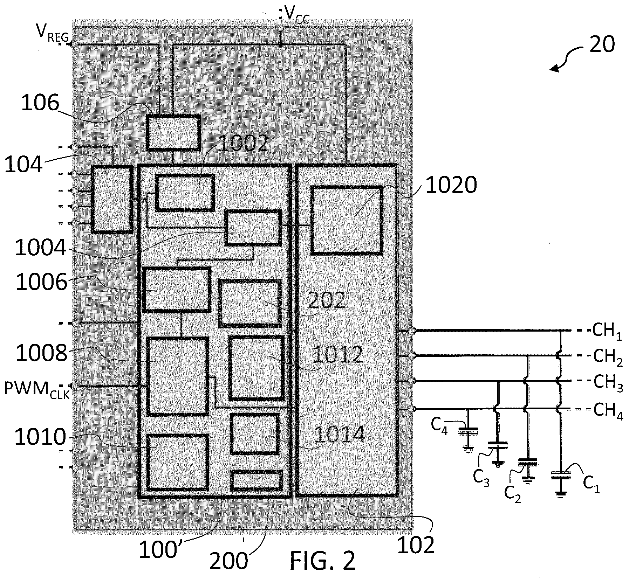

Figure 2 is a block diagram of a high-side driver 20 according to embodiments of the present description.

In the following, blocks, elements and/or components which have already been described with reference to Figure 1 are denoted by the same references, therefore, the description of such previously described elements will not be repeated herein to not overburden the present description.

Figure 2 illustrates a high-side driver 20 comprising, in addition to the elements already described in Figure 1, an E-Fuse ("Electronic-Fuse") 200 and a parallel-mode block 202, both comprised in a logic section 100' (corresponding to the logic section 100 of Figure 1 but further comprising the components described in Figure 2).

The E-Fuse 200, for instance, an I2t (optionally CCM, that is, implementing a Capacitive Charging Mode) E-Fuse, may be configured to:
monitor, for instance, continuously, at least one parameter for each channel in the plurality of channels CH, for instance, harness currents and/or other parameters used to detect anomalous conditions,
use each of the at least one monitored parameter related to a respective channel in the plurality of channels CH to check for anomalous conditions in such respective channel;
perform protection operations (such as channels internal protections and diagnosis) based on the detected anomalous conditions, for instance, independently, that is, without interferences from an external microcontroller (or any other equivalent external unit, for instance, a microprocessor, a logic unit, or the like), and
(optionally) be compatible with (even large) capacitive loads, for instance, by enabling a specific feature such as a Capacity Charging Mode, CCM feature.
I2t (Current Squared times time) is an electrical quantity that is commonly used to determine energy to a protective device, such as a circuit breaker or fuse.

Protection operations as considered herein are performed on parallelized channels as a group (even if such protection operations may be individually active for each of the parallelized channel driving a same load) and not on each of such parallelized channels individually, therefore, for instance, in case of a thermal event (or any other fault/anomalous condition) on at least one of the parallelized channels, each of the parallelized channels is decoupled from the load or turned off, that is, turned into a non-conductive state, and thus, interrupting the currents flowing within each of the parallelized channels driving the same load.

In fact, the protections and diagnosis performed on each of the channels may be active and separate from those of the other channels but the triggering of at least one protection related to a channel in a set of parallelized channels driving a same given load may trigger also the protections of the other channels in such set of parallelized channels.

The protection operations may comprise one or more operations out of: power limitation, thermal shutdown, current limitation, and I2t trip time scaling (that is, the scaling of the harness protection, wherein the I2t trip time describes the quadratic law for which a cable can sustain a current for a time without melting).

In addition, the protection operations may further comprise harness protections using the average of the currents flowing within the parallelized channels as tripping current, thus, adapting such harness protections to the parallel-mode (that is, the operation of the high-side driver with parallelized channels), for instance, using additional logic.

It is noted that the OTP 1010 may retain information about the configuration of each of the channels and other useful information, for instance, information about testing and trimming.

The parallel-mode block 202, if enabled, is configured to define at least one set of channels comprising at least two channels of the plurality of channels CH, each of such channels comprised in such at least one set of channels being configured to drive a same respective load, thus, such parallel-mode block 202 is configured to define channels to be parallelized.

The parallel-mode block 202 may be further configured to configure and activate such channels to be parallelized (that is, the channels comprised in a same set of channels and driving a same load) and to synchronously manage such parallelized channels, for instance, by providing activation and synchronization control signals to the PWM engine 1008.

Thus, such PWM engine 1008 may be further configured to use the information of such activation and synchronization control signals to manage parallelized channels correctly, for instance, by generating the one or more channel control signals as a function of such received activation and synchronization control signals.

For instance, such parallel-mode block 202 may be enabled by setting a digital enable, for instance, by setting the bit(s) of an enabling register of the SPI block 104 to a high logic level (or a low logic level),. by setting in real-time the bit(s) of one or more of the registers within such parallel-mode block 202, or through any other enabling signal or any other register setting.

The parallel-mode block 202 may contain at least one channel control register for each channel CH, such at least one channel control register being configured to be linked to the respective channel and to have stored therein configuration parameters for such respective channel, therefore, such driver apparatus 20 may comprise channel control registers configured to have stored therein configuration parameters for respective channels in the plurality of channels CH.

In fact, if a channel is enabled and configured to be parallelized with other channels, that is, configured to supply the same load of such other channels, the at least one channel control register that corresponds to such channel is configured to store configuration parameters for such channel, such configuration parameters may be used, for instance, by the parallel-mode block 202 in order to provide to the PWM engine 1008 activation and synchronization control signals in order to facilitate an activation and a synchronously management of such channel and of the other channels that are to be parallelized with such channel.

It is noted that the configuration parameters associated with parallelized channels (driving the same load) stored in respective channel control registers may advantageously be equal, thus, the channel control registers of the channels in a same set of channels, that is, the set of channels comprising the channels that are configured to be parallelized in order to drive a same load, may be configured to have stored therein identical configuration parameters for the respective channels in said same set of channels and the control module, for instance, the PWM engine 1008, may be configured to receive from the parallel-mode block 202 parallel-mode management control signals, that is, activation and synchronization control signals, based on said identical configuration parameters.

In this way, each of the control commands that is addressed to one of the parallelized channels may be equal to the control commands addressed to the others of the parallelized channels, thus, facilitating a synchronized management of such parallelized channels.

In fact, the parallel-mode block 202 may be further configured to ignore control commands addressed to the others of the parallelized channels if such control commands are different from those addressed to one of the parallelized channels (that is, an update control register selected out of such channel control registers), for instance, the first channel receiving control commands or a specific channel designated to receive control commands, in order to avoid their desynchronization.

Therefore, the channel control registers of the channels in a same set of channels may be configured to:
receive, at an update control register out of said channel control registers of the channels in said same set of channels, an update request of said identical configuration parameters,
update said identical configuration parameters in the channel control registers of the channels in said at least one set of channels in response to said update request received at said update control register, and
ignore other update requests of said identical configuration parameters received at channel control registers of the channels in said at least one set of channels different from said update control register.

It is noted that such added blocks, that is, the E-Fuse 200 and the parallel-mode block 202 may not influence other blocks in the logic section 100, for instance, the ADC 1004, and/or the current sense block 1020 contained in the section containing gate drivers and MOSFETs 102.

Therefore, solutions as described herein facilitate reducing the number of high-side drivers integrated within a single silicon device without reducing compatibility with loads having different current requirements since a high number of high-side drivers with different current capabilities may be substituted with a smaller number of high-side drivers 20 configured to parallelize the output channels in order to drive loads with higher current requirements.

In addition, such an advantage may be provided without reducing the high-side drivers robustness since protection operations may be performed on parallelized channels as a group and the control commands addressed to each of the parallelized channels may be kept synchronized.

Therefore, solutions as described herein may facilitate obtaining higher performance, robustness, and greater versatility in managing end-applications as high-side drivers as described herein can drive different configurations of loads, for instance, in a current range from about 1.5A till about 30A, even reducing the occupied area.

It is noted that such current range may be even wider if, instead of a monolithic high-side driver, a hybrid one is considered, that is, high-side drivers with a control stage in one die and a power stage in another die, the two dies being assembled in one package.

To summarize, a driver apparatus 20, for instance, a high-side driver apparatus, as described herein may comprise:
a plurality of channels CH configured to drive one or more electrical loads, for instance, using respective power MOSFETs coupled to such electrical load;
a control module, for instance, the PWM engine 1008, configured to generate one or more channel control signals, for instance, one or more PWM signals, to operate at least one channel in the plurality of channels CH;
an electronic fuse 200 configured to monitor one or more parameters, for instance, harness currents or the like, in a respective channel in the plurality of channels CH and to detect anomalous conditions in the respective channel based on the one or more monitored parameters;
a parallel-mode block 202 configured to define one or more sets of channels including two or more channels of the plurality of channels CH, the channels in a same set of channels being configured to drive a same load, that is, such channels comprised in a same set of channels are configured to be parallelized.

The control module 1008 may be configured to receive from the parallel-mode block 202 parallel-mode management control signals, for instance, such activation and synchronization control signals, and to operate the channels in said one or more sets of channels based on said parallel-mode management control signals received by the parallel-mode block 202, and the electronic fuse 200 may be configured to make the channels in a same set of channels non-conductive in response to an anomalous condition detected in at least one channel in said at least one set of channels.

Solutions as that of Figure 2 using an E-Fuse 200 which is not provided with compatibility with capacitive loads (or loads comprising capacitive components) may not provide for the management of such type of loads.

Managing capacitive loads may be useful in different applications, for instance, in automotive applications.

In fact, at each power on of a vehicle, a controlled pre-charging of the capacitors comprised in the ECUs ("Electronic Control Unit") and/or different capacitive loads comprised in the power distribution domain is to be performed.

It is noted that a discharged capacitor (or a discharged capacitive load) may be modeled as a short circuit, therefore, the usage of a high-side driver 20 for pre-charging (even big) capacitors or, generally, capacitive loads, may result in (high) inrush currents flowing within the high-side driver components.

Such inrush currents may lead to a thermal shutdown of the corresponding high-side driver 20, thus, interrupting the charging of the capacitive loads.

For instance, a first approach which may avoid such thermal shutdown comprises performing the pre-charge of the capacitive loads using a dedicated unit configured to manage a train of current pulse peaks, irrespective of the thermal behavior the power MOSFETs comprised in the channels of the corresponding high-side driver.

Therefore, using such an approach may not provide for the possibility of optimizing the charging time versus the thermal capabilities of the power MOSFETs comprised in the channels as the thermal behavior of such power MOSFETs is not considered.

In fact, current pulses used in such first approach may depend only on a programmed frequency and there is no loopback from the thermal protections (that is, is an open loop solution).

In addition, problems related to the management of (very) high current peaks may arise, for instance, the sizing of the ground connections may be critical.

Therefore, a different solution is described herein, such solution comprising the implementation of an additional module, that is, a CCM module, on the high-side driver 20, for instance, implemented within the E-Fuse 200 and coupled to the PWM engine 1008.

Such CCM module is configured to provide compatibility with capacitive loads, enabling the operation of at least one power MOSFET comprised within a respective channel of the high-side driver 20 in a CCM ("Capacitive Charging Mode") mode, such at least one power MOSFET being coupled to a load comprising a capacitive component.

Enabling of the CCM mode may involve limiting:
the current flowing within such at least one power MOSFET, and
the thermal increase of the at least one power MOSFET with respect to the chip temperature, such additional thermal increase being considered with respect to the thermal increase affecting such at least one power MOSFET during "normal" operations, that is, when capacitive loads are already pre-charged, such CCM mode being enabled in order to charge capacitive loads in a certain (desired) time range, and thus, performing such pre-charging based on the actual MOSFETs temperatures instead of a train of current pulse peaks.

It is noted that the CCM module may be integrated within the E-Fuse 200 and coupled to the PWM engine 1008, therefore, without adding components to the high-side driver 20.

It is noted that such CCM mode, that is, a mode to manage an operative condition of at least one power MOSFET comprised within a channel of the high-side driver 20 when such power MOSFET is coupled with a load comprising a capacitive component that is to be pre-charged (that is, candidate for pre-charging), may be available both in Fail Safe, that is, devices that in presence of failures respond in a way that may cause minimal or no harm to other equipment, to environment or to people, and Normal mode devices, that is, non-fail-safe devices.

Solutions as described herein facilitate solving the previous problem, thus, providing even wider load compatibility (being even compatible with capacitive loads and loads comprising capacitive components that are to be pre-charged) and further reducing the number of components as a further high-side driver dedicated to the pre-charging of such capacitive loads may not be used, for instance, the dedicated unit configured to manage the train of current pulse peaks previously described may be avoided.

Therefore, solutions as described herein may comprise:
performing a smooth charging of the capacitive loads that are to be pre-charged using a (low or moderate) RMS ("Root Mean Square") current, and
disabling the harness protections of the E-Fuse 200 during the pre-charging of such capacitive loads, that is, during the CCM mode.

It is noted that solutions as described in the following may advantageously be used even in high ambient temperature conditions and to drive capacitive loads both on parallelized channels and individual channels, depending on respective configuration parameters (stored in the parallel-mode block 202).

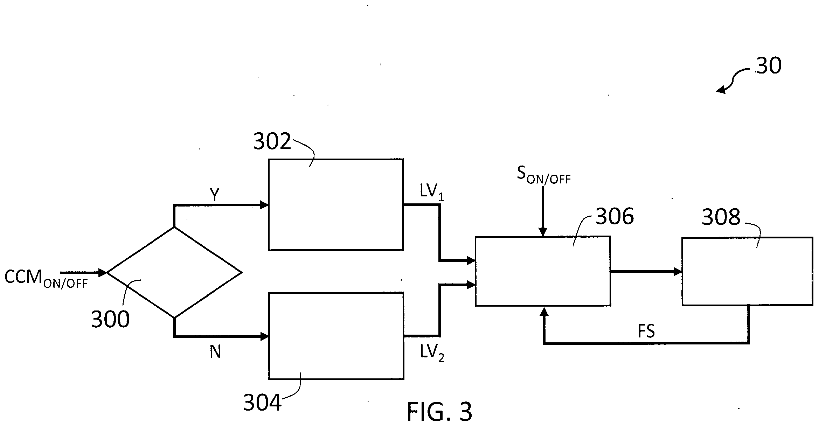

Figure 3 is a diagram 30 comprising steps, for instance, partially implemented in the CCM module, and components involved in the operation of at least one power MOSFET (represented by block 308 of the diagram 30) comprised in a channel of a high-side driver 20 in presence of capacitive loads, according to embodiments of the present description.

Such operation of at least one power MOSFET 308 comprised in a channel of a high-side driver 20 according to the diagram 30 of Figure 3 may advantageously facilitate the charging of capacitive loads during a certain time range and without turning off the power MOSFETs, that is, making them non-conductive, in response to thermal shutdown.

The first block of the diagram 30 is a checking block 300 that comprises steps performed, for instance, by the CCM module, such steps comprising:
receiving a start signal CCM_{ON/OFF} indicating if the CCM mode is to be used to operate at least one power MOSFET 308 comprised in a channel of the high-side driver 20 or not,
checking whether such CCM mode is to be used to operate such at least one power MOSFET 308 of the high-side driver 20 using the information of such start signal CCM_{ON/OFF},
if the checking step determines that the CCM mode is to be used, generating a first output check signal Y (indicated in the diagram 30 by the first output check branch Y) and proceeding to a first setting block 302 comprising a first setting step, and
if the checking step determines that no CCM mode is to be used, generating a second output check signal N (indicated in the diagram 30 by the second output check branch N) and proceeding to a second setting block 304 comprising a second setting step.

The first setting block 302 comprises a first setting step, for instance, implemented using the CCM module, comprising selecting, in response to the reception of the first output check signal Y, a first set of limit values LV₁ comprising limit values for the current flowing within such at least one power MOSFET 308, that is, output current limitation thresholds, and the thermal increase of the at least one power MOSFET 308 with respect to the chip temperature , such thermal increase being considered with respect to the thermal condition of such at least one power MOSFET 308 during normal operations.

For instance, exemplary values for such limit values may be (it is noted that such values are provided herein by way of example only and are not limitative for the scope of protection of the present document):
a limit value I_{limL} for the current flowing within such at least one power MOSFET 308 may be equal to the forty percent (that is, 40%) of the maximum current I_{limH} that may flow within such at least one power MOSFET 308 before a possible damage or before triggering thermal shutdown;
a limit value ΔT_{PL} for the thermal increase of the at least one power MOSFET with respect to the chip temperature may be equal to 35°C.

The first setting step may further comprise providing such first set of limit values LV₁ to a controller block 306, for instance, implemented within the PWM engine 1008, so that the limit values comprised in such first set of limit values LVi may be used during the operation of the at least one power MOSFET 308 in CCM mode.

The second setting block 304 comprises a second setting step, for instance, implemented using the CCM module or by default when not using such CCM module, comprising selecting, in response to the reception of the second output check signal N, a second set of limit values LV₂ comprising limit values for the current flowing within such at least one power MOSFET 308, that is, output current limitation thresholds, and the thermal increase of the at least one power MOSFET 308 with respect to the chip temperature, such thermal increase being considered with respect to the thermal condition of such at least one power MOSFET 308 during normal operations.

It is noted that the limit values comprised in the second set of limit values LV₂ may be higher than the respective limit values comprised in the first set of limit values LV₁.

For instance, exemplary values for the limit values comprised in the second set of limit values LV₂ may be (it is noted that such values are provided herein by way of example only and are not limitative for the scope of protection of the present document):
a limit value I_{limH} for the current flowing within such at least one power MOSFET 308, that is, the maximum current I_{limH} that may flow within such at least one power MOSFET 308 before a possible damage or before triggering thermal shutdown;
a limit value ΔT_{PL} for the thermal increase that may affect such at least one power MOSFET 308 may be equal to 80°C.

The second setting step may further comprise providing such second set of limit values LV₂ to the controller block 306 so that the limit values comprised in such second set of limit values LV₂ may be used during the operation of the at least one power MOSFET 308 in an operative mode different from the CCM mode.

The controller block 306 may comprise steps performed, for instance, within the PWM engine 1008, such steps comprising enabling or disabling one or more high-side driver functions based on the reception of a function enabling/disabling signal S_{ON/OFF} indicating to enable or disable such functions (or a subset of such functions) for the duration of the CCM mode, that is, when the start signal CCM_{ON/OFF} indicates that the CCM mode is to be used to operate at least one power MOSFET 308 of the high-side driver 20.

For instance, if the steps comprised within the controller block 306 are performed within the PWM engine 1008, such PWM engine 1008 may be further configured to send a set of control signals to the E-Fuse 200 in response to the reception of such function enabling/disabling signal S_{ON/OFF}, for instance, indicating to disable the harness protections and/or to enable TSD ("Thermal ShutDown") auto-restart (not delayed) for the duration of the CCM mode.

Otherwise, if the steps comprised within the controller block 306 are performed within the E-Fuse 200, the enabling/disabling signal S_{ON/OFF} that indicates to enable or disable protection functions may be received by such E-Fuse 200 that, for instance, may be further configured to disable the harness protections and/or to enable TSD ("Thermal ShutDown") auto-restart (not delayed) for the duration of the CCM mode in response to the reception of such enabling/disabling signal S_{ON/OFF}.

The steps comprised within the controller block 306 may further comprise:
receiving the first set of limit values LV₁ from the first setting step comprised in the first setting block 302 or the second set of limit values LV₂ from the second setting step comprised in the second setting block 304,
receiving a feedback signal FS from the at least one power MOSFET represented by block 308 (that is, from the at least one channel comprising such at least one power MOSFER 308), such feedback signal FS indicating the actual value of the current flowing therein and its actual thermal increase, and
driving the at least one power MOSFET 308 based on the received signals/values (that is, the function enabling/disabling signal S_{ON/OFF}, the first set of limit values LV₁ or the second set of limit values LV₂, and the feedback signal FS).

It is noted that the solution of Figure 3 is a closed loop implementation that facilitates:
considering also the actual conditions of the at least one power MOSFET 308, that is, of the corresponding channel comprising such at least one power MOSFET 308, in order to drive such power MOSFET 308, that is, such corresponding channel, and
modulating the charging performance of the capacitive components of the loads to obtain a desired charging time, for instance, selecting different limit values for such first set of limit values LV₁ in order to obtain such desired charging time.

Such close loop implementation may facilitate an optimization of the pre-charging of such capacitive components of the loads since the thermal behavior of the power MOSFETs 308 is provided as feedback to the steps comprised in the controller block 306, thus, such steps may use such information to optimize the driving of such respective power MOSFETs.

In this way, the power MOSFETs may be turned from a conductive state to a non-conductive state only when there is a risk for a thermal shutdown and thus the time needed to pre-charge such capacitive components of the loads may be minimized.

In addition, by selecting a desired value for the limit values in the first set of limit values LV₁ it may be possible to charge the capacitive components of the loads in a certain (desired) time range, for instance, 100 ms.

Therefore, solutions using a CCM mode (for instance, according to the diagram 30 described in Figure 3) may advantageously be more versatile in managing end applications (that is, in managing different types of loads) since even loads comprising a (even big) capacitive component to be pre-charged may be considered.

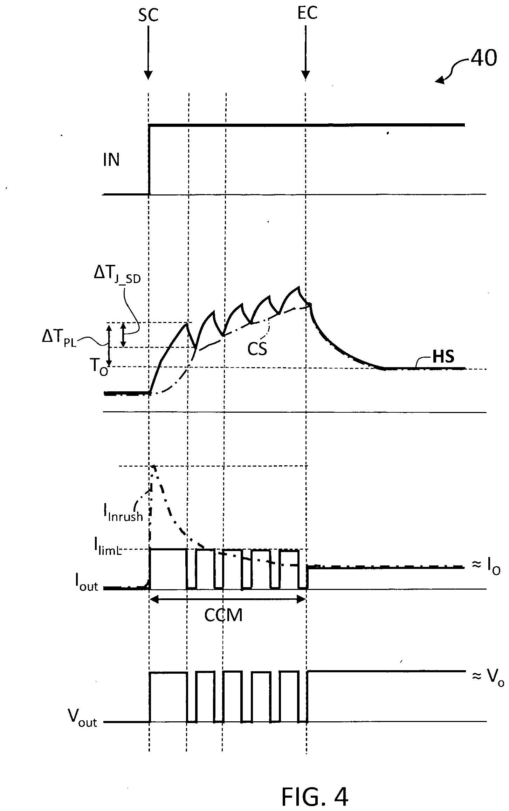

Figure 4 is a time diagram 40 of the behavior of signals related to a high-side driver 20 when operated according to the diagram of Figure 3 according to embodiments of the present description.

The pre-charge of the capacitive loads (or the capacitive components of the loads) coupled to power MOSFETs 308 that are to be operated in CCM mode starts at a start charge time SC in response to the commutation of an input signal IN, for instance, from a low logic level to a high logic level (for instance, corresponding to the power on of a vehicle).

In response to the commutation of the input signal IN, the CCM mode is enabled in order to operate at least one power MOSFET 308 that is coupled to a load comprising capacitive components that are to be pre-charged, such CCM mode being enabled through the start signal CCM_{ON/OFF}, thus, the first set of limit values LV₁ is selected and the function enabling/disabling signal S_{ON/OFF}, for instance, indicates to disable the harness protections and to enable TSD auto-restart (not delayed).

In addition, as previously described, the driving step comprised in the controller block 306 performed, for instance, using the PWM engine 1008, may drive the at least one power MOSFET 308 coupled to such load comprising capacitive components that are to be pre-charged making it conductive, therefore, an output current I_{OUT} with a limited value equal to the selected current limit value I_{limL} (comprised in the first set of limit values LVi) starts flowing within such at least one power MOSFET 308 and a corresponding output voltage V_{OUT} of value equal to Vo is applied thereto.

It is noted that the exemplary inrush current I_{Inrush} illustrated in Figure 4 (dotted-dashed line) may be an example of the behavior of a current flowing in the at least one power MOSFET 308 if no CCM mode is used during the pre-charge of the capacitive components comprised in the load coupled thereto, such inrush current I_{Inrush} having high values that may result in a thermal shutdown of such at least one power MOSFET 308.

In response to the output current I_{OUT} flowing within the at least one power MOSFET 308, the temperature of such at least one power MOSFET 308 (that is, its junction temperature) may increase above an operating temperature To, that is, the (junction) temperature of the at least one power MOSFET 308 when coupled to capacitive loads that are already pre-charged.

Such increasing temperatures may result from the value of such output current I_{OUT} flowing within the at least one power MOSFET 308, that is, the limit value I_{limL}, being higher than the operative value Io of the current flowing in such at least one power MOSFET 308 when capacitive loads are already pre-charged.

It is noted that in Figure 4 are illustrated temperature behaviors measured using two different temperature sensors: a temperature behavior measured using a hot sensor HS and a temperature behavior measured using a cold sensor CS.

Such temperature behaviors can be used to detect two different kinds of thermal protections: thermal shut down protections and power limitation protections.

Thermal shut down protections can be triggered when the temperature of the junction of the power MOSFET Tⱼ, referred to as HS in Figure 4, measured through the hot sensor reaches an absolute threshold value T_{j_SD}, for instance, equal to 180°C.

In such cases, the power MOSFET 308 is switched off until the temperature of its junction Tⱼ, HS cools down to a first thermal shut down reset threshold T_{j_SD_R}, wherein such first thermal shut down reset threshold T_{j_SD_R} is equal to the absolute threshold value T_{j_SD} minus 7°C, that is, T_{j_SD_R} = T_{j_SD} - 7°C.

When the temperature of the junction Tⱼ, HS of the power MOSFET 308 reaches the first thermal shut down reset threshold T_{j_SD_R}, such power MOSFET 308 can be turned on again.

A thermal shut down diagnostic flag can be triggered when the thermal protection is activated, that is, when the power MOSFET 308 is switched off, and can be resetted when the temperature of the junction Tⱼ, HS of the power MOSFET 308 reaches a second thermal shut down reset threshold T_{j_SD_RS}, wherein such second thermal shut down reset threshold T_{j_SD_RS} is equal to the absolute threshold value T_{j_SD} minus 15°C, that is, T_{j_SD_RS} = T_{j_SD} - 15°C.

It is noted that while the thermal shut down diagnostic flag is triggered, the current flowing within such at least one power MOSFET 308 is limited by the current limit value I_{limL}. instead of the current limit value I_{limH}.

Power limitation protections can be triggered when the temperature of the junction of the power MOSFET Tⱼ, HS measured through the hot sensor reaches a relative threshold ΔT_{j_PL} considered with respect to the temperature of the chip of about 80°C, that is, ΔT_{j_PL} = Tⱼ - T_{chip} = 80°C.

Such temperature of the chip T_{chip} can be measured using the cold sensor, therefore, it is referred to as CS in Figure 4.

In such cases, the power MOSFET 308 is switched off until a relative temperature ΔTⱼ measured between the power MOSFET 308 and the chip, that is, ΔTⱼ = Tⱼ - T_{chip}, cools down by 7°C, therefore, reaching a first power limitation reset threshold ΔT_{j_PL_R} = ΔT_{j_PL} - 7°C.

When the relative temperature ΔTⱼ reaches the above-mentioned value, such power MOSFET 308 can be turned on again.

A power limitation diagnostic flag can be triggered when the thermal protection is activated, that is, when the power MOSFET 308 is switched off, and can be resetted when the relative temperature ΔTⱼ reaches a value equal to a second power limitation reset threshold ΔT_{j_PL_RS} = ΔT_{j_PL} - 15°C.

If the CCM mode is active, the relative threshold ΔT_{j_PL} can be decreased to 35°C (instead of 80°C) and the current flowing within such at least one power MOSFET 308 is limited by the current limit value I_{limL}, for instance, equal to the forty percent (40%) of the current limit value I_{limH}.

The relative temperature ΔTⱼ in the cases described above remains unchanged, that is, equal to ΔT_{j_PL_R} = ΔT_{j_PL} - 7°C to turned on again the power MOSFET 308 and to ΔT_{j_PL_RS} = ΔT_{j_PL} - 15°C to reset the power limitation diagnostic flag.

It is noted that if the CCM mode is active, also the first thermal shut down reset threshold T_{j_SD_R} and the second thermal shut down reset threshold T_{j_SD_RS} remain unchanged.

If the temperature of (the junction of) such at least one power MOSFET 308 increases above the operating temperature T_{O} of an amount higher than the selected thermal increase limit value ΔT_{PL} (comprised in the first set of limit values LV₁), reaching the relative threshold ΔT_{j_PL}, the driving step comprised in the controller block 306 performed, for instance, using the PWM engine 1008, may drive the at least one power MOSFET 308 making it non-conductive, thus, the output current I_{OUT} and the output voltage V_{OUT} reach a value that is substantially zero (considering a given tolerance).

When the at least one power MOSFET 308 is in a non-conductive state, its (junction) temperature starts decreasing.

When such temperature decreases of an amount equal to/higher than a given temperature amount, for instance 7°C, that is, reaching the first power limitation reset threshold ΔT_{j_PL_R}, resulting in the actual temperature of such at least one power MOSFET 308 being smaller than the sum of the operating temperature To and the selected thermal increase limit value ΔT_{PL} of an amount equal to such given temperature amount, such at least one power MOSFET 308 can be restarted by, for instance, the PWM engine 1008, that is configured to perform again the driving step comprised in the controller block 306 in order to turn again such at least one power MOSFET 308 into a conductive state, resulting in a corresponding output current I_{OUT} with a value equal to the selected current limit value I_{limL} flowing therein and an output voltage V_{OUT} of value equal to Vo applied thereto.

It is noted that the CCM mode may be active for the time needed to complete the pre-charging of the capacitive loads, that is, up to an end charge time EC, for instance, about 100 ms after the start charge time SC.

After such end charge time EC, the CCM mode may be disabled and the at least one power MOSFET 308 may be configured to drive the corresponding load in a "normal" mode, that is, a mode used when capacitive loads are already pre-charged, therefore, a current with an operative value Io is flowing therein and a voltage with an operative value Vo is applied thereto.

Therefore, solutions as described herein may provide compatibility with capacitive loads (or loads with - even big - capacitive components that are to be pre-charged) by enabling the operation of at least one power MOSFET 308 comprised in a channel of the high-side driver 20 in a CCM mode, thus, providing wider load compatibility and further reducing the number of components used.

In addition, the pre-charging of the capacitive components of the loads coupled with one or more power MOSFETs is performed by the currents flowing within such power MOSFETs, such currents being limited to a predetermined value (that is, the value comprised in the first set of limit values LV₁) and by limiting of a predetermined value the thermal increase that may affect such power MOSFETs (that is, again the value comprised in the first set of limit values LV₁), thus, facilitating charging (even big) capacitive loads in a certain time range, reducing the critical referencing to ground, and enabling such CCM mode without the intervention of an external elaboration unit, for instance, a microcontroller, a microprocessor, a logic unit, or the like.

In addition, being the thermal increase that may affect the power MOSFETs and the value of the currents flowing within such power MOSFETs limited, such CCM mode may be used also with capacitive loads with a greater capacitive component and even in high ambient temperature conditions.

In addition, by changing the values of the limits for the thermal increase that may affect the power MOSFETs and the currents flowing within such power MOSFETs it is possible to complete the pre-charging of the capacitive components of the loads in a (desired) given time.

To summarize, a driver apparatus 20 as described herein may comprise an additional module, for instance, implemented in the additional CCM module, for instance, comprised in the E-Fuse 200, configured to:
receive, for instance, in a checking block 300, a start signal CCM_{ON/OFF} indicating if one or more channels in the plurality of channels CH are coupled to a load (one or more loads) comprising a capacitive component candidate for pre-charging;
select, for instance, in a first setting block 302, a first set of limit values LV₁ for driver operating parameters in response to the start signal CCM_{ON/OFF} indicating that one or more channels in the plurality of channels CH are coupled to a load (one or more loads) comprising a capacitive component candidate for pre-charging; and
select, for instance, in a second setting block 304, a second set of limit values LV₂ for said driver operating parameters, said second set of limit values LV₂ comprising limit values higher than or equal to the limit values in the first set of limit values LV₁ in response to the start signal CCM_{ON/OFF} indicating that no channel in the plurality of channels CH is coupled to a load comprising a capacitive component candidate for pre-charging.

The control module 1008, 306 may be configured to:
receive the first set of limit values LV₁ or the second set of limit values LV₂ from said additional module CCM based on said start signal CCM_{ON/OFF};
receive a feedback signal FS providing actual values for driver operating parameters out of said driver operating parameters, said actual values being related to the one or more channels in the plurality of channels CH coupled to the (one or more) load(s) comprising the capacitive component candidate for pre-charging;
drive the one or more channels in the plurality of channels CH coupled to the (one or more) load(s) comprising the capacitive component candidate for pre-charging based on said feedback signal FS and on the limit values in said first set of limit values LV₁ or said second set of limit values LV₂.

Said driver operating parameters may include:
currents flowing within said one or more channels in the plurality of channels CH coupled to the (one or more) load(s) comprising the capacitive component candidate for pre-charging; and
a thermal increase affecting said one or more channels in the plurality of channels CH coupled to the (one or more) load(s) comprising the capacitive component candidate for pre-charging, said thermal increase being an excess of temperature affecting said one or more channels in the plurality of channels CH coupled to the (one or more) load(s) comprising the capacitive component in response to said capacitive component being pre-charged.

In addition, the electronic fuse 200 may be configured to perform protection operations selected out of:
harness protection, wherein the electronic fuse 200 may be configured to disable harness protection based on a function enabling/disabling signal S_{ON/OFF} generated in response to said start signal CCM_{ON/OFF}; and/or
non-delayed thermal shutdown auto-restart, wherein the electronic fuse 200 may be configured to enable non-delayed thermal shutdown auto-restart based on said function enabling/disabling signal S_{ON/OFF}.

The E-Fuse 200 comprised in a high-side driver 20 as described herein may advantageously be configured to implement additional protection functions, for instance, comprising one or more BISTs ("Built-In Self-Test") used to check if the ADC 1004 or the harness protections are working correctly (for instance, such check being performed after each coming out of the respectively monitored devices from a standby state).

Such additional protection functions may be useful, for instance, in automotive vehicles as an increasing number of applications and/or devices is to be safety relevant or compliant to ISO ("International Organization for Standardization"), thus, more software and hardware countermeasures may be helpful to fulfill ASIL ("Automotive Safety Integrity Level") grades.

To be compliant with ISO 26262 (defining functional safety for automotive equipment throughout the lifecycle of the automotive electronic and electrical safety-related systems), safety mechanisms like duplication/lockstep, DCLS and logic triplication, TMR may be used but such mechanisms may have substantial impacts on silicon area, power, and cost.

Therefore, a frequently considered solution comprise using circuitry that can be used for both functional safety and manufacturing test, including structures such as BIST.

Built-in self-tests, BISTs are structural test methods that can be used as safety mechanisms for functional safety and that add logic to an integrated circuit, IC used to periodically test its own operation, checking if functional safety requirements are met.

However, known BISTs structure can suffer of latent fault detection on ADCs and may not evaluate FIT ("Failure In Time") rate/coverage, thus, being not compliant with ASIL grade B.

Solutions as described herein may facilitate solving such issue of latent fault detection on Analog to Digital Converters (for instance, using an ADC BIST) and may facilitate improving FIT ("Failure In Time") rate and reliability of harness protection analog comparators (for instance, using an I2t BIST), therefore, solutions as described herein may fulfil ASIL grade B.

Solutions as described herein may comprise:
a first BIST circuitry B₁ used to check if functional safety requirements of an ADC, for instance, the ADC 1004 comprised in the high-side driver 20, are met, and
a second BIST circuitry B₂ used to check if functional safety requirements of harness protection analog comparators, for instance, the analog comparators of the harness protections of the E-Fuse 200, are met.

Thus, BISTs circuitry of the solutions as described herein (collectively referred to as B) may provide an automatic checking of the ADC conversions and of the health of the analog comparators of the harness protections along the working life of respective devices.

For instance, such BISTs circuitry B may be configured to perform such checking operations after each POR ("Power On Reset") signal generation, that is, each time after the respective devices exit from a standby mode.

It is noted that the first BIST circuitry B₁ and the second BIST circuitry B₂ may be considered independently, therefore, a high-side driver 20 may comprise only one of the two BISTs or both of them.

The first BIST circuitry B₁ is configured to inhibit the feedback information received by the ADC 1004 from the current sense block 1020 about the sensed current flowing within each of the channels for the duration of the operations performed by such first BIST circuitry B₁.

The first BIST circuitry B₁ is configured to generate, for instance, from a same reference current signal, three different current signals indicative of different current levels, that is, a low reference current LC, a middle reference current MC, and a high reference current HC, and to provide such three current signals to respective input terminals of a first multiplexer, for instance, that is comprised in the circuitry of such first BIST B₁.

Thus, the ADC 1004 may be further configured to receive the low reference current LC, the mid reference current MC, and the high reference current HC, for instance, sequentially from the output terminal of the first multiplexer, and, for each received reference current, it may be configured to convert the received reference current into a corresponding current digital value.

The current digital values obtained from such conversions may be sent to the first BIST circuitry B₁, for instance, to a first BIST digital section of such first BIST circuitry B₁, and stored in respective ADC BIST registers comprised in such first BIST digital section, therefore:
a first ADC BIST register comprised in such first BIST digital section of the first BIST circuitry B₁ can be configured to store a current digital value corresponding to the low reference current LC converted through the ADC 1004, such current digital value being a low-level digital current value for self-test,
a second ADC BIST register comprised in such first BIST digital section can be configured to store a current digital value corresponding to the mid reference current MC converted through the ADC 1004, such current digital value being a medium-level digital current value for self-test, and
a third ADC BIST register comprised in such first BIST digital section can be configured to store a current digital value corresponding to the high reference current HC converted through the ADC 1004, such current digital value being a high-level digital current value for self-test.

Hence, a first BIST elaboration unit (for instance, comprised within the first BIST circuitry B₁ or external), for instance, a logic unit, a microcontroller, a microprocessor, or the like, may be configured to read the digital current values for self-test stored in such respective ADC BIST registers and to compare such digital current values with a current acceptance mask.

For instance, such current acceptance mask may contain the current digital values that are expected from the ADC conversion.

Therefore, if the digital current values stored within such respective ADC BIST registers are equal to that of the current acceptance mask, the BIST operations performed by the the first BIST circuitry B₁ may be considered successful and the functional safety requirements of the analog to digital converter 1004 are considered as met.

Otherwise, if the digital current values stored within such respective ADC BIST registers are different from that of the current acceptance mask, the BIST operations performed by the the first BIST circuitry B₁ may be considered failed and an anomalous condition may be present, thus, the functional safety requirements of the analog to digital converter 1004 are considered as not met.

An R&C (that is, "Read and Clear") command can be sent, for instance, by such first BIST elaboration unit, to the respective ADC BIST registers containing the digital current values in order to detect any stuck bit.

Such sending of the R&C command may allow an external elaboration unit, for instance, an external microcontroller or the like, to read register values and, at the same time, to reset the contents of such register to a default content, for instance, to a content containing all zeros.

Therefore, in case of any logic stuck, either low or high, a R&C command may allow to detect a register hardware fault.

At the end of such checking operations (thus, at the end of the first BIST B₁ operations), the first BIST circuitry B₁ is further configured to inhibit the low reference current LC, the mid reference current MC, and the high reference current HC, and the feedback information received by the ADC 1004 from the current sense block 1020 about the sensed current flowing within each of the channels is restored, thus, the ADC is configured again to operate as described for Figure 2.

It is noted that such a configuration may be kept until a next power on reset, POR of the ADC 1004, when further BIST operations are performed by the first BIST circuitry B₁.

To summarize, driver apparatus 20 as described herein may comprise:
a current sense block 1020 configured to sense currents flowing in the channels in the plurality of channels CH; and
an analog-to-digital converter, ADC 1004 configured to receive channel currents sensed for the channels in the plurality of channels CH and to convert the sensed channel currents into digital channel current signals.

The control module 1008 may be configured to generate one or more channel control signals to operate one or more channels in the plurality of channels CH based on the digital channel current signal corresponding to said one or more channels, and wherein the electronic fuse 200 comprises ADC built-in self-test, BIST circuitry, that is, such first BIST circuitry Bi, configured to perform a self-test as to functional safety requirements being met in said analog-to-digital converter 1004.

The ADC BIST circuitry, that is, such first BIST circuitry Bi, may be configured to:
generate a plurality of reference current signals, for instance, the low reference current LC, the mid reference current MC, and the high reference current HC, indicative of different reference current levels, and
provide the plurality of reference current signals, for instance, such low LC, mid MC, and high HC reference currents, to the analog-to-digital converter 1004.

The analog-to-digital converter 1004 may be configured to receive and convert the plurality of reference current signals into digital reference current signals, and the ADC BIST circuitry, that is, such first BIST circuitry Bi, may be configured to perform said self-test as to functional safety requirements being met in said analog-to-digital converter 1004 by:
receiving and comparing the digital reference current signals with a current acceptance mask,
considering functional safety requirements in said analog-to-digital converter 1004 as being met in response to the digital reference current signals matching said current acceptance mask and as not being met in response to the digital reference current signals failing to match said current acceptance mask.

It is noted that the ADC BIST circuitry may be configured to disable current sensing by the current sense block 1020 during said self-test as to functional safety requirements being met in the analog-to-digital converter 1004.

The second BIST circuitry B₂ is configured to disable the harness protections of the E-Fuse 200 for the duration of the operations performed by such second BIST circuitry B₂.

The second BIST circuitry B₂ is configured to generate, for instance, from a same reference voltage level, three different voltage levels, that is, a first (low) reference voltage level LV, a second (mid) reference voltage level MV, and a third (high) reference voltage level HV, and to apply such three different voltage levels to respective input terminals of a second multiplexer 500.

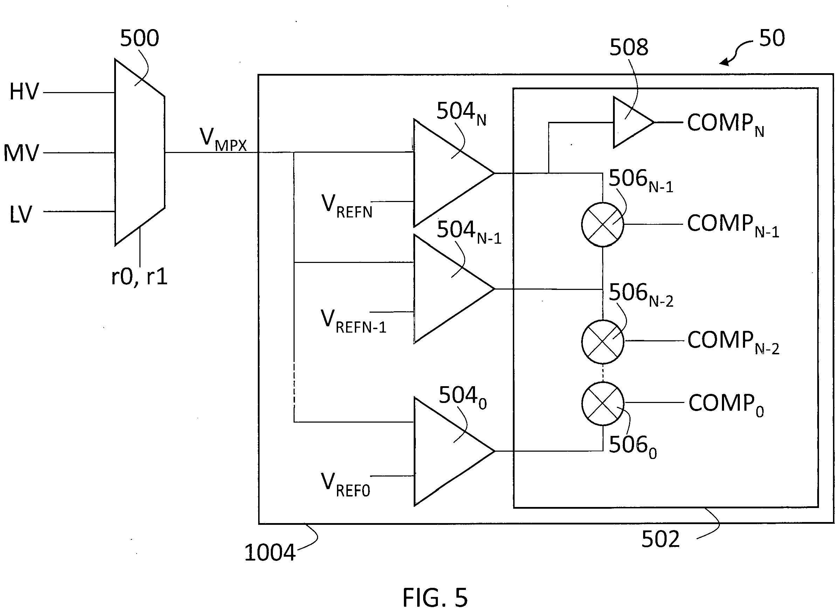

For instance, Figure 5 illustrates part of the second BIST ("Built in Self-Test") circuitry B₂ used in high-side drivers 20 to check the functional safety of harness protection analog comparators according to embodiments of the present description.

In fact, Figure 5 illustrates the coupling 50 between such second multiplexer 500 configured to receive the low reference voltage level LV, the mid reference voltage level MV, and the high reference voltage level HV, and the ADC 1004.

It is noted that such ADC 1004 may be of any known type, for instance, (by way of example only and without limiting the scope of protection of the present document) it may comprise:
an analog part comprising a plurality of comparators (504₀, ..., 504_{N-1}, 504_{N}, collectively referred to as 504) configured to compare a voltage input signal V_{MPX} that is to be converted into a digital value with a plurality of voltage reference signals (V_{REF0}, ..., V_{REFN-1}, V_{REFN}, collectively referred to as V_{REF}) indicating different voltage levels, and
a logic part 502 comprising a plurality of XOR operators (506₀, ..., 506_{N-2}, 506_{N-1}, collectively referred to as 506) configured to receive the outputs of such plurality of comparators 504 and to perform XOR operations on pair of such outputs, obtaining a plurality of comparison values (COMP₀, ..., COMP_{N-2}, COMP_{N-1}, collectively referred to as COMP) and a comparison value COMP_{N} obtained by inverting 508 the logical level of the output of the last converter 504_{N}, such comparison values being further processed (for instance, using an encoder) to obtain the digital representation of such voltage input signal V_{MPX}.

It is noted that such a structure may be easily adapted to obtain an equivalent figure for the first BIST circuitry B₁, for instance, by changing the voltage signals into current signals or by transforming the current levels into voltage level and then using the same structure.

Therefore, the ADC 1004 may be further configured to receive the low reference voltage level LV, the mid reference voltage level MV, and the high reference voltage level HV, for instance, sequentially from the output terminal of the second multiplexer 500 (for instance, wherein such sequence is obtained using a multiplexer control signal comprising two bits r0 and r1), and, for each received reference voltage V_{MPX}, it may be configured to convert the received reference voltage V_{MPX} into a corresponding voltage digital value.

Thus, after a conversion delay the voltage digital values obtained from such conversions may be sent to the second BIST circuitry B₂, for instance, to a second BIST digital section of such second BIST circuitry B₂, and stored in respective harness BIST registers comprised in such second BIST digital section, therefore:
a first harness BIST register comprised in such second BIST digital section of the second BIST circuitry B₂ can be configured to store a voltage digital value corresponding to the low reference voltage level LV converted through the ADC 1004,
a second harness BIST register comprised in such second BIST digital section can be configured to store a voltage digital value corresponding to the mid reference voltage level MV converted through the ADC 1004, and
a third harness BIST register comprised in such second BIST digital section can be configured to store a voltage digital value corresponding to the high reference voltage level HV converted through the ADC 1004.

Hence, a second BIST elaboration unit (for instance, comprised within the second BIST circuitry B₂ or external), for instance, a logic unit, a microcontroller, a microprocessor, or the like, may be configured to read the voltage digital values stored in such respective harness BIST registers and to compare such voltage digital values with a voltage acceptance mask.

It is noted that such second BIST elaboration unit may be a shared elaboration unit between such second BIST circuitry B₂ and the first BIST circuitry B₁ if both the BISTs circuitry are present within a same high-side driver 20, therefore, saving additional components.

For instance, such voltage acceptance mask may contain the voltage digital values that are expected from the ADC conversion.

Therefore, if the voltage digital values stored within such respective harness BIST registers are equal to that of the voltage acceptance mask, the BIST operations performed by the the second BIST circuitry B₂ may be considered successful and at least one corresponding bit may be set to a high logic level to indicate such successful condition, thus, the functional safety requirements of the harness protection are considered met.

Otherwise, if the voltage digital values stored within such respective harness BIST registers are different from that of the voltage acceptance mask, the BIST operations performed by the the second BIST circuitry B₂ may be considered failed and an anomalous condition may be present, thus, at least one corresponding bit may be set to a low logic level to indicate such anomalous condition, thus, the functional safety requirements of the harness protection are considered not met.

It is noted that during the BIST operations performed by the second BIST circuitry B₂ the plurality of channels of the corresponding high-side driver 20 may be kept disabled until such BIST operations end.

At the end of such checking operations (thus, at the end of the second BIST B₂ operations), the second BIST circuitry B₂ is further configured to inhibit the multiplexer 500 by setting it in high impedance, and the harness protections of the E-Fuse 200 are restored, thus, such E-Fuse 200 is configured again to operate as described for Figure 2.

It is noted that such a configuration may be kept until a next power on reset, POR of the E-Fuse 200, when further BIST operations are performed by the second BIST circuitry B₂.

To summarize, the electronic fuse 200 may be configured to provide harness protection, thus, such driver apparatus 20 as described herein may comprise harness protection built-in self-test, BIST circuitry, that is, the second BIST circuitry B₂, configured to perform a self-test as to functional safety requirements being met by said harness protection.

Thus, the driver apparatus 20 may comprise an analog-to-digital, ADC converter, for instance, the same ADC 1004 of Figure 2 or a different one, configured to receive one or more input signals and to convert said one or more received input signals into a digital output signal, and the harness protection BIST circuitry, that is, the second BIST circuitry B₂, may be configured to:
generate a plurality of reference voltage signals, for instance, the low reference voltage level LV, the mid reference voltage level MV, and the high reference voltage level HV, indicative of different voltage levels, and
provide said plurality of reference voltage signals to the analog-to-digital converter 1004, wherein the analog-to-digital converter 1004 may be configured to receive and convert said plurality of reference voltage signals into digital reference voltage signals.

The harness protection BIST circuitry may be configured to perform said self-test as to functional safety requirements being met by said harness protection by:
receiving and comparing the digital reference voltage signals with a voltage acceptance mask,
considering functional safety requirements in said harness protection as being met in response to the digital reference voltage signals matching said voltage acceptance mask and as not being met in response to the digital reference voltage signals failing to match said voltage acceptance mask.

In addition, the harness protection BIST circuitry B2 may be configured to disable harness protection provided by the electronic fuse 200 during said self-test as to functional safety requirements being met in said harness protections.

It is noted that said self-test as to functional safety requirements may be performed in response to power on reset (POR) signals, for instance, in response to the ADC 1004 or the harness protections exiting from a standby mode.

Such BISTs circuitry comprised within the logic section 100 of such high-side driver 20 is to be supplied with a certain power, for instance, by power supply architecture.

Such power supply architecture may be also used to provide a continuous and stable voltage supply to other digital components of the high-side driver 20.

For example, in automotive applications battery glitches or short supply interruptions may occur that interrupt the operations of such BISTs circuity, thus, increasing the time requested for performing functional safety checks and/or increasing the probability of missed or wrong detections.

In fact, in automotive applications the power supply may come from the battery of a considered vehicle, thus, in response to the variety and number of electronic devices comprised and used within such considered vehicle, the battery voltage level may be affected by glitches, fluctuations, short interruptions, cranks, and oscillations.

The digital components that regulate the operativity and protections of such high-side driver 20, for instance, such BISTs circuity B₁, B₂ described herein, is to be stable and reliable in order to be compliant with automotive standards.

In fact, for instance, having an unreliable ad unstable BISTs circuity B₁, B₂ in response to an unreliable and unstable power supply architecture may result in missed or late anomalies detection, for instance, missing or late detecting anomalies in the ADC 1004 or in the analog comparators of the harness protections, leading to possible critical situations.

In addition, if such battery glitches or short supply interruptions happens when the ADC BIST registers comprised in the first BIST digital section of the first BIST circuitry B₁ or the harness BIST registers comprised in such second BIST digital section of the second BIST circuitry B₂ store respective current or voltage digital value, such registers may lose their content with a consequent failure of the performed functional safety checks.

A first solution may be to use a power supply structure for digital components coming from the supply rail of a microcontroller, or the like, but such a solution may still suffer from fluctuations and instabilities of the supply voltage of such microcontroller, thus, in case of not stable supply voltage both the microcontroller and the corresponding digital component supplied by it, for instance, the BISTs circuity B₁ and B₂, may be reset, for instance, ADC BIST registers or harness BIST registers may lose their content.

Such a reset may not be an issue for the microcontroller (or the like) or for some of the digital components, but it may compromise the correct activities of such BISTs circuity B₁ and B₂, for instance, since the information contained in the harness BIST registers of the second BIST circuitry B₂ may be lost, leading to harness overheating and unpredicted failure.

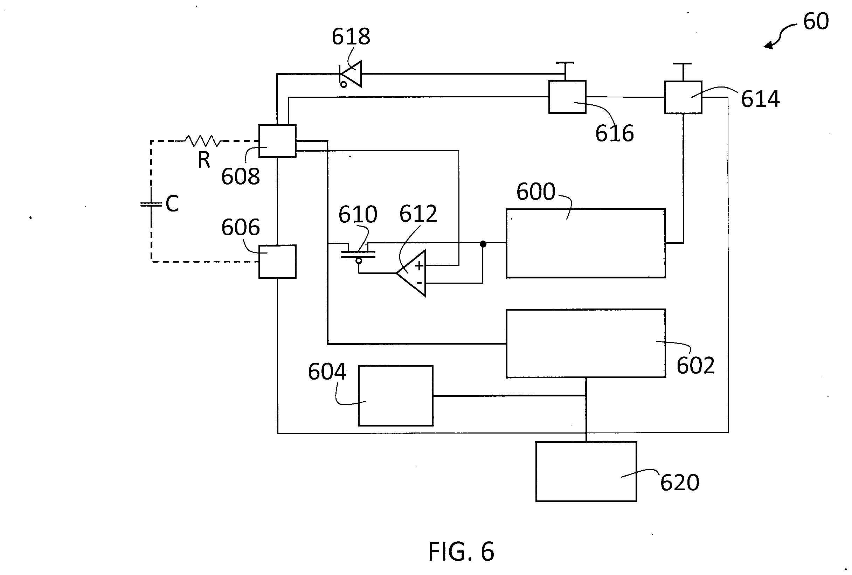

To this purpose, an enhanced digital power supply structure 60 is illustrated in Figure 6 according to embodiments of the present description.

It is noted that, advantageously, such enhanced digital power supply structure 60 may be used to supply also other digital components 620 comprised in a high-side driver, for instance, the high-side driver 20 described herein, thus, obtaining such described advantages even for them.

Battery glitches or short supply interruptions are regulated by the LV124 norm, that is, a norm defining the testing procedures (comprising electrical tests, mechanical tests, weather tests, and duration tests) for electronic and electrical vehicle components, and an enhanced digital power supply structure 60 as that illustrated in Figure 6 may facilitate reaching a compliance with such norm.

Such digital power supply structure 60 is based on the use of an external capacitor C coupled to a corresponding high-side driver 20 through a dedicated pin, such external capacitor C being further configured to supply the digital components of such high-side driver 20 and to protect such digital components in case of battery glitches or short supply interruptions in order to increase the level of protection for the high-side driver 20 itself and for the loads coupled therewith.

As previously described, such a protection function may also be useful to retain information stored in volatile registers during such battery glitches or short supply interruptions.

Solutions as described herein may facilitate providing the previously described advantages for any operating condition of the high-side driver 20, for instance, retaining the volatile registers content, thus, retaining configuration information and information useful for protections, facilitating providing reliable and functional protections and reducing digital logic resets.

It is noted that architecture described in the following is configured to prevent the external capacitor C to be discharged towards a battery line when a condition V_{pre_reg}>V_{bat} is valid. In fact, the charge stored in the external capacitor C can be used only to supply the internal circuitry, that is, the digital components 620, and is not wasted into the failing battery line.

A vehicle battery, can be configured to provide a global supply voltage V_{bat} (for instance, a global supply voltage of about 13V), for instance, in order to supply the components comprised within such vehicle, through a battery pin 614.

A device supplying unit for instance, the supply rail of a corresponding microcontroller (or the like), can be configured to receive the global supply voltage V_{bat}, and to generate a scaled supply voltage V_{DD}, for instance, a scaled supply voltage of about 5V.

Such scaled supply voltage V_{DD} can be provided to a scaled voltage pin 616, such scaled supply voltage V_{DD} being the same voltage as the one supplying the external elaboration unit, for instance, a microcontroller or the like.

Therefore, the digital power supply structure 60 comprise a reference, that is, the scaled voltage pin 616, for such scaled supply voltage V_{DD} in order to be aligned with the external elaboration unit and to correctly receive communications from the SPI block 104, for instance, through digital pins like SDI, CNS, SCK, SDO, PWM CLK, which are internally supplied by the voltage of the scaled voltage pin 616.

The digital power supply structure 60 described herein may comprise receiving from such voltage supplies, that is, from the vehicle battery and the device supplying unit:
the scaled supply voltage V_{DD} through the scaled voltage pin 616, and
the global supply voltage V_{bat} through the battery pin 614.

The digital power supply structure 60 may be configured to:
generate a pre-regulated voltage, that is, a digital supply voltage V_{pre_reg}, from the battery pin 614 to a dedicated pin 608 through a voltage pre-regulator 600 and a switch circuity configured to implement an internal active diode 610-612, and
provide the digital supply voltage V_{pre_reg} to the external capacitor C, such external capacitor C being, for instance, coupled between a dedicated pin 608 through a resistor R and a ground terminal 606, thus, increasing the amount of charge stored therein (that is, charging it up to a voltage level substantially equal to - considering a given tolerance - the value of such digital supply voltage V_{pre_reg}).

The digital power supply structure 60 may be configured to forward a digital supply voltage V_{pre_reg} on such dedicated pin 608 based on such received scaled supply voltage V_{DD}. It is noted that the coupling between the scaled voltage pin 616 and the dedicated pin 608 through an external diode 618 is optional.

The digital power supply structure 60 may be further configured to provide (irrespective of the operating conditions of the high-side driver 20) the digital supply voltage V_{pre_reg} to a voltage regulator unit 602 in order to facilitate supplying the digital components 620 (for instance, comprising such BISTs circuity B₁ and B₂) comprised in such high-side driver 20.

Therefore, such dedicated pin is the pin wherein both the output terminal of the voltage pre-regulator 600, the external capacitor C, and an input terminal of the voltage regulator unit 602 may be coupled.

Thus, such voltage regulator unit 602 can be configured to receive at its input terminal a voltage that is the voltage applied to such dedicated pin, therefore:
if no glitches, fluctuations, short interruptions, cranks, and/or oscillations are present on the external supplies, the dedicated pin is set to a voltage value equal to the digital supply voltage V_{pre_reg} supplied by the voltage pre-regulator 600, and
if glitches, fluctuations, short interruptions, cranks, and/or oscillations are present on the external supplies, such voltage pre-regulator 600 fails in providing such digital supply voltage V_{pre_reg}, thus, the dedicated pin is supplied by a capacitor voltage Vc, that is, the voltage applied to the network comprising the external capacitor C and the resistor R and (optionally) coming from the external diode 618.

It is noted that such digital supply voltage V_{pre_reg} and such capacitor voltage Vc, that is, the voltage applied to the external capacitor C, may be equal in steady-state conditions.

In fact, such voltage pre-regulator 600 and such external capacitor C (through the resistor R) are coupled between the same nodes, that are, such dedicated pin and the ground terminal 606, and therefore, in a steady-state condition the digital supply voltage V_{pre_reg} and the capacitor voltage Vc have a same value.

In this way, the voltage applied to such dedicated pin received by the voltage regulator unit 602 (through its input terminal) may be a substantially constant voltage (considering a given tolerance) since the digital supply voltage V_{pre_reg} (if anomalies on the external supplies are absent) and the capacitor voltage Vc (if anomalies on the external supplies are present) applied to such dedicated pin have a same value, thus, facilitating providing a stable supply voltage to such digital components 620.

In fact, the voltage regulator unit 602 is further configured to generate a circuit supply voltage Vcc, for instance, a circuit supply voltage of about 3V, based on the voltage applied to such dedicated pin, that is, the digital supply voltage V_{pre_reg} and/or the capacitor voltage Vc, and to provide such circuit supply voltage Vcc to the digital components 620, for instance, comprising such BISTs circuity B₁ and B₂, and to a LVD unit 604.

It is noted that an optional external active diode 618 may facilitate a synchronization between the dedicated pin 608 and the scaled voltage pin 616, for instance, coupled to a supply rail of a corresponding elaboration unit, for instance, a microcontroller (or the like).

An internal active switch 610, for instance, a MOSFET ("Metal-Oxide-Semiconductor Field-Effect Transistor"), a BJT ("Bipolar Junction Transistor"), or the like, may be configured to have its current drain terminal coupled to a pre-regulator unit 600, its current source terminal coupled to the dedicated pin 608 and to the voltage regulator unit 602, and its control terminal to the output terminal of an amplifier 612 that receives at its input terminals the value of the voltage provided by the pre-regulator unit 600 and the value of the voltage seen on the dedicated pin 608.

Such internal active switch 610 and such amplifier 612 may be configured to implement an internal active diode 610-612 that is configured to limit the discharge of the external capacitor C if the global supply voltage V_{bat} supplied by the battery pin 614 falls in response to glitches, fluctuations, short interruptions, cranks, and oscillations.

The pre-regulator unit 600 may be configured to receive the global supply voltage V_{bat} from the battery pin 614 and to operate the internal active diode 610-612 based on such global supply voltage V_{bat}, for instance, if such global supply voltage V_{bat} falls, the pre-regulator unit 600 may be configured to open the internal active switch 610 in order to make the internal active diode 610-612 non-conductive, thus, limiting the discharge of the external capacitor C.

The LVD ("Low Voltage Detector") unit 604 is a protection module that may be configured to disconnect the digital components 620 from the voltage regulator unit 602 to save battery power when the circuit supply voltage Vcc of the voltage regulator 602 drops blow a minimum supply voltage threshold for the digital components 620, facilitating a further starting of such digital components 620 in response to enough power being left in such battery pin 614.

It is noted that such circuit supply voltage Vcc provided by the voltage regulator unit 602 may remain stable even in presence of glitches, fluctuations, short interruptions, cranks, and/or oscillations of the external supplies.

In fact, if the digital supply voltage V_{pre_reg} is substantially equal (considering a given tolerance) to the capacitor voltage Vc, the voltage received as input by such voltage regulator unit 602, that is, the voltage applied to such dedicated pin (thus, such digital supply voltage V_{pre_reg} or such capacitor voltage Vc), may be constant and not affected by such glitches, fluctuations, short interruptions, cranks, and/or oscillations of the external supplies.

In fact, even when the global supply voltage V_{bat} falls, the pre-regulator unit 600 may, for instance, open the internal active switch 610 in order to make the internal active diode 610-612 non-conductive in order to limit the discharge of the external capacitor C, thus, trying to maintain stable the voltage applied to such dedicated pin, that is, the capacitor voltage Vc.

Therefore, in response to falls of the global supply voltage V_{bat} supplied by the battery pin 614, the voltage regulator unit 602 may be configured to generate the circuit supply voltage V_{CC} based on the substantially constant (considering a given tolerance) voltage applied to such dedicated pin, providing a more stable (and without interruption) voltage supply to such digital components 620.

Hence, solutions as described herein may advantageously provide for:
retaining the content of the volatile registers, for instance, the ADC BIST registers comprised in the first BIST digital section of the first BIST circuitry B₁ and/or the harness BIST registers comprised in such second BIST digital section of the second BIST circuitry B₂, since the voltage supplied to such digital components 620, that is, the circuit supply voltage Vcc, may be more stable and not affected by changes in the global supply voltage V_{bat} supplied by the battery pin 614;
improved reliability of protections, for instance, an improved reliability of the BISTs circuitry B₁ and B₂ as described herein, since without losing the supply voltage, for instance, the BISTs circuitry B₁ and B₂ as described herein is resistant against missed or late anomalies detection; and/or
independence of the voltage regulator unit 602, that is, an independence of the unit configured to supply such digital components 620, from external supplies, since in case of glitches, fluctuations, short interruptions, cranks, and/or oscillations of the external supplies, the voltage regulator unit 602 may still be configured to provide a substantially stable (considering a given tolerance) circuit supply voltage Vcc to such digital components 620 for a given time (such time depending on the time required for the discharge of the external capacitor C) since the capacitor voltage V_{C} applied to the external capacitor C may compensate for the variation of the voltage provided by the external supplies.

It is noted that the slower is the discharge of the external capacitor C, the longer may be the time in which the voltage regulator unit 602 may still be able to provide a substantially stable circuit supply voltage Vcc to such digital components 620.

To summarize, solutions as described herein may comprise:
a voltage pre-regulator 600 configured to produce a pre-regulated supply voltage, for instance, the digital supply voltage V_{pre_reg}, for the apparatus 20,
a capacitor, for instance, the external capacitor C, coupled to a dedicated pin 608, the capacitor C may be configured to be charged to a capacitor charge voltage, that is, the capacitor voltage Vc, equalling the pre-regulated supply voltage V_{pre_reg}; and
switch circuitry, for instance, the active diode 610-612, coupled to the voltage pre-regulator 600 through the switch circuitry 610-612 and configured to detect a voltage drop in the pre-regulated supply voltage V_{pre_reg} and to counter discharge of the capacitor C with respect to said charge voltage V_{C} equalling the pre-regulated supply voltage V_{pre_reg} in response to detecting a voltage drop in the pre-regulated supply voltage V_{pre_reg}.

In addition, a supply unit, for instance, the scaled voltage pin 616, may be configured to:
receive a scaled supply voltage V_{DD} based on said battery supply voltage, for instance, the global supply voltage V_{bat}; and
apply said scaled supply voltage V_{DD} to the dedicated pin 608, for instance, through the external diode 618, in the driver apparatus 20 to produce said pre-regulated supply voltage V_{pre_reg} from said scaled supply voltage V_{DD}.

Solutions as described herein facilitate achieving a driver apparatus, for instance, a high-side driver apparatus, comprising a plurality of channels configured to drive one or more loads, for instance, electrical loads, and a control module configured to generate one or more channel control signals to operate one or more respective channels.

Such apparatus may further comprise an electronic fuse ("E-Fuse") configured to monitor one or more parameters of such channels and to use such one or more monitored parameters to detect anomalous channel conditions, and a parallel-mode block configured to define one or more sets of channels (comprising at least two channels).

It is noted that the channels in a same set of channels defined by such parallel-mode block are configured to drive a same load.

In addition, the control module of solutions as described herein may be further configured to receive from the parallel-mode block management control signals and to operate the channels in the one or more sets of channels based on the received management control signals, and the electronic fuse of solutions as described herein may be further configured to make the channels in a same set of channels non-conductive in response to an anomalous condition detected in one or more channels comprised in such set of channels.

In embodiments, a high-side driver apparatus as described herein may comprise an additional module configured to provide compatibility with load comprising one or more capacitive components that are to be pre-charged.

In embodiments, a high-side driver apparatus as described herein may comprise one or more BISTs circuitry configured to check if functional safety requirements of an analog to digital converter comprised therein and/or of implemented harness protections are met.

In embodiments, a high-side driver apparatus as described herein may comprise an enhanced digital power supply comprising a capacitor configured to be charged in order to supply a dedicated pin in case of falls of a global supply voltage.

Thus, solutions as described herein facilitate reducing the number of high-side drivers integrated within a single silicon device without reducing robustness and compatibility with loads having different current requirements in order to reduce the occupied areas and the amount of circuitry used, still providing compatibility with different types of loads.

In addition, embodiments of the solutions described herein may facilitate providing additional compatibility with loads comprising one or more capacitive components (even during their pre-charging phase).

Embodiments of the solutions described herein may facilitate implementing additional protections in high-side driver apparatus as described herein.

Embodiments of the solutions described herein may further facilitate providing continuous and stable voltage supply to digital components (for instance, comprising such implemented additional protections) of high-side driver apparatus as described herein.

Without prejudice to the underlying principles, the details and the embodiments may vary, even significantly, with respect to what has been described by way of example only without departing from the scope of the embodiments.

The extent of protection is determined by the annexed claims.

## Claims

1. An apparatus (20), comprising:
a plurality of channels (CH) configured to drive at least one electrical load;
a control module (1008) configured to generate at least one channel control signal to operate at least one channel in the plurality of channels (CH);
wherein the apparatus (20) comprises:
an electronic fuse (200) configured to monitor at least one parameter in a respective channel in the plurality of channels (CH) and to detect anomalous conditions in the respective channel based on the at least one monitored parameter;
a parallel-mode block (202) configured to define at least one set of channels including at least two channels of the plurality of channels (CH), the channels in said at least one set of channels being configured to drive a same load,
wherein:
the control module (1008) is configured to receive from the parallel-mode block (202) parallel-mode management control signals and to operate the channels in said at least one set of channels based on said parallel-mode management control signals received by the parallel-mode block (202), and
the electronic fuse (200) is configured to make the channels in said at least one set of channels non-conductive in response to an anomalous condition detected in at least one channel in said at least one set of channels.

2. The apparatus (20) according to claim 1, comprising channel control registers configured to have stored therein configuration parameters for respective channels in the plurality of channels (CH).

3. The apparatus (20) according to claim 2, wherein the channel control registers of the channels in said at least one set of channels are configured to have stored therein identical configuration parameters for the respective channels in said at least one set of channels and the control module (1008) is configured to receive from the parallel-mode block (202) parallel-mode management control signals based on said identical configuration parameters.

4. The apparatus (20) according to claim 3, wherein the channel control registers of the channels in said at least one set of channels are configured to:
receive, at an update control register out of said channel control registers of the channels in said at least one set of channels, an update request of said identical configuration parameters,
update said identical configuration parameters in the channel control registers of the channels in said at least one set of channels in response to said update request received at said update control register, and
ignore other update requests of said identical configuration parameters received at channel control registers of the channels in said at least one set of channels different from said update control register.

5. The apparatus (20) according to any of the previous claims, comprising an additional module (CCM) configured to:
receive (300) a start signal (CCM_{ON/OFF}) indicating if at least one channel in the plurality of channels (CH) is coupled to a load comprising a capacitive component candidate for pre-charging;
select (302) a first set of limit values (LV₁) for driver operating parameters in response to the start signal (CCM_{ON/OFF}) indicating that at least one channel in the plurality of channels (CH) is coupled to a load comprising a capacitive component candidate for pre-charging; and
select (304) a second set of limit values (LV₂) for said driver operating parameters, said second set of limit values (LV₂) comprising limit values higher than or equal to the limit values in the first set of limit values (LV₁) in response to the start signal (CCM_{ON/OFF}) indicating that no channel in the plurality of channels (CH) is coupled to a load comprising a capacitive component candidate for pre-charging;
and wherein the control module (1008; 306) is configured to:
receive the first set of limit values (LV₁) or the second set of limit values (LV₂) from said additional module (CCM) based on said start signal (CCM_{ON/OFF});
receive a feedback signal (FS) providing actual values for driver operating parameters out of said driver operating parameters, said actual values being related to the at least one channel in the plurality of channels (CH) coupled to the load comprising the capacitive component candidate for pre-charging;
drive the at least one channel in the plurality of channels (CH) coupled to the load comprising the capacitive component candidate for pre-charging based on said feedback signal (FS) and on the limit values in said first set of limit values (LV₁) or said second set of limit values (LV₂).

6. The apparatus (20) according to claim 5, wherein said driver operating parameters include:
a current flowing within said at least one channel in the plurality of channels (CH) coupled to the load comprising the capacitive component candidate for pre-charging; and
a thermal increase affecting said at least one channel in the plurality of channels (CH) coupled to the load comprising the capacitive component candidate for pre-charging, said thermal increase being an excess of temperature affecting said at least one channel in the plurality of channels (CH) coupled to the load comprising the capacitive component in response to said capacitive component being pre-charged.

7. The apparatus (20) according to claim 5 or claim 6, wherein the electronic fuse (200) is configured to perform protection operations selected out of:
harness protection, wherein the electronic fuse (200) is configured to disable harness protection based on a function enabling/disabling signal (S_{ON/OFF}) generated in response to said start signal (CCM_{ON/OFF}); and/or
non-delayed thermal shutdown auto-restart, wherein the electronic fuse (200) is configured to enable non-delayed thermal shutdown auto-restart based on said function enabling/disabling signal (S_{ON/OFF}).

8. The apparatus (20) according to any of the previous claims, comprising:
a current sense block (1020) configured to sense currents flowing in the channels in the plurality of channels (CH); and
an analog-to-digital converter, ADC (1004) configured to receive channel currents sensed for the channels in the plurality of channels (CH) and to convert the sensed channel currents into digital channel current signals;
wherein the control module (1008) is configured to generate at least one channel control signal to operate at least one channel in the plurality of channels (CH) based on the digital channel current signal corresponding to said at least one channel;
and wherein the electronic fuse (200) comprises ADC built-in self-test, BIST circuitry (B₁) configured to perform a self-test as to functional safety requirements being met in said analog-to-digital converter (1004).

9. The apparatus (20) according to claim 8, wherein the ADC BIST circuitry (B₁) is configured to:
generate a plurality of reference current signals (LC; MC; HC) indicative of different reference current levels, and
provide the plurality of reference current signals (LC; MC; HC) to the analog-to-digital converter (1004);
wherein the analog-to-digital converter (1004) is configured to receive and convert the plurality of reference current signals (LC; MC; HC) into digital reference current signals;
and wherein the ADC BIST circuitry (Bi) is configured to perform said self-test as to functional safety requirements being met in said analog-to-digital converter (1004) by:
receiving and comparing the digital reference current signals with a current acceptance mask,
considering functional safety requirements in said analog-to-digital converter (1004) as being met in response to the digital reference current signals matching said current acceptance mask and as not being met in response to the digital reference current signals failing to match said current acceptance mask.

10. The apparatus (20) according to claim 9, wherein the ADC BIST circuitry (Bi) is configured to disable current sensing by the current sense block (1020) during said self-test as to functional safety requirements being met in the analog-to-digital converter (1004).

11. The apparatus (20) according to any of the previous claims, wherein the electronic fuse (200) is configured to provide harness protection and comprises harness protection built-in self-test, BIST circuitry (B₂) configured to perform a self-test as to functional safety requirements being met by said harness protection.

12. The apparatus (20) according to claim 11, wherein said apparatus (20) comprises an analog-to-digital, ADC converter (1004) configured to receive at least one input signal and to convert said at least one received input signal into a digital output signal;
and wherein the harness protection BIST circuitry (B₂) is configured to:
generate a plurality of reference voltage signals (LV; MV; HV) indicative of different voltage levels, and
provide said plurality of reference voltage signals (LV; MV; HV) to the analog-to-digital converter (1004), wherein the analog-to-digital converter (1004) is configured to receive and convert said plurality of reference voltage signals (LV; MV; HV) into digital reference voltage signals;
and wherein the harness protection BIST circuitry (B₂) is configured to perform said self-test as to functional safety requirements being met by said harness protection by:
receiving and comparing the digital reference voltage signals with a voltage acceptance mask,
considering functional safety requirements in said harness protection as being met in response to the digital reference voltage signals matching said voltage acceptance mask and as not being met in response to the digital reference voltage signals failing to match said voltage acceptance mask.

13. The apparatus (20) according to claim 12, wherein the harness protection BIST circuitry (B2) is configured to disable harness protection provided by the electronic fuse (200) during said self-test as to functional safety requirements being met in said harness protections.

14. The apparatus (20) according to any of claims 8 to 13, wherein said self-test as to functional safety requirements is performed in response to power on reset signals.

15. The apparatus (20) according to any of the previous claims, comprising:
a voltage pre-regulator (600) configured to produce a pre-regulated supply voltage (V_{pre_reg}) for the apparatus (20),
a capacitor (C) coupled to a dedicated pin (608), the capacitor (C) configured to be charged to a capacitor charge voltage (Vc) equalling the pre-regulated supply voltage (V_{pre_reg}); and
switch circuitry (610-612) coupled to the voltage pre-regulator (600), the switch circuitry (610-612) configured to detect a voltage drop in the pre-regulated supply voltage (V_{pre_reg}) and to counter discharge of the capacitor (C) with respect to said charge voltage (V_{C}) equalling the pre-regulated supply voltage (V_{pre_reg}) in response to detecting a voltage drop in the pre-regulated supply voltage (V_{pre_reg}), wherein, preferably said switch circuitry (610-612) being further configured to detect a voltage drop on a battery line (V_{bat}) coupled to said voltage pre-regulator (600) and, in response to said detection, to avoid a discharge of the capacitor (C).

16. The apparatus (20) according to claim 15, comprising a supply pin (616) configured to:
receive a battery supply voltage through a battery pin (614);
receive a scaled supply voltage (V_{DD}) based on said battery supply voltage (V_{bat}); and
apply said scaled supply voltage (V_{DD}) to the dedicated pin (608) in the apparatus (20) to produce said pre-regulated supply voltage (V_{pre_reg}) from said scaled supply voltage (V_{DD}), preferably, though a diode (618).

17. A method of operation of an apparatus (20) according to any of the previous claims having at least one electrical load coupled to said plurality of channels (CH) to be driven, wherein the method comprises:
the electronic fuse (200) monitoring at least one parameter in a respective channel in the plurality of channels (CH) and detecting anomalous conditions in the respective channel based on the at least one monitored parameter;
the parallel-mode block (202) defining said at least one set of channels including at least two channels of the plurality of channels (CH),
the control module (1008) receiving parallel-mode management control signals from the parallel-mode block (202) and operating the channels in said at least one set of channels based on said parallel-mode management control signals received by the parallel-mode block (202), and
the electronic fuse (200) making the channels in said at least one set of channels non-conductive in response to an anomalous condition detected in at least one channel in said at least one set of channels.
